# EUROPÄISCHE PATENTSCHRIFT

(11) **EP 3 533 299 B1**
(45) Veröffentlichungstag und Bekanntmachung des Hinweises auf die Patenterteilung: **03.06.2026**
(21) Anmeldenummer: 17797089.4
(22) Anmeldetag: 25.10.2017
(51) Int. Cl.: H05K 1/02, H05K 1/05, G02B 6/42, H05K 3/46, H05K 3/44, H05K 1/181

(54) **ELEKTRISCH-OPTISCHER AUFBAU**
ELECTRO-OPTICAL STRUCTURE
MONTAGE ÉLECTRO-OPTIQUE

(30) Priorität: 26.10.2016 DE 102016221137
(43) Veröffentlichungstag der Anmeldung: 04.09.2019
(73) Patentinhaber: Deutsches Zentrum für Luft- und Raumfahrt e.V., 51147 Köln (DE)
(72) Erfinder: SCHMIDT, Christopher, 82194 Gröbenzell (DE); FUCHS, Christian, 80637 München (DE)
(74) Vertreter: dompatent
(86) Internationale Anmeldenummer: PCT/EP2017/077290
(87) Internationale Veröffentlichungsnummer: WO 2018/077941

(56) Entgegenhaltungen:
- EP-A1- 0 346 038
- EP-A1- 1 220 390
- EP-A1- 3 045 945
- EP-A2- 0 841 698
- US-A1- 2010 309 483
- US-B1- 6 639 155

## Beschreibung

Die Erfindung betrifft einen elektrisch-optischen Aufbau mit einer gemeinsamen Leiterplatte zur Aufnahme elektrischer und auch optischer Komponenten.

Üblicherweise werden elektrische Schaltungen auf einer Leiterplatte montiert. Die elektronischen Komponenten werden dabei entsprechend einem Schaltplan durch Leiterbahnen verbunden, die in eine zumeist Kupferbeschichtung der Leiterplatte insbesondere durch einen Ätzprozess eingebracht werden. Bei Bau von Systemen, insbesondere zur optischen Kommunikation, werden jedoch sowohl elektronische Komponenten, als auch optische Komponenten verwendet. Üblicherweise werden dabei die elektronischen Komponenten auf einer Leiterplatte montiert. Die optischen Komponenten werden auf einer optischen Bank montiert in Form einer Grundplatte, durch die die stabile Montage der optischen Komponenten sichergestellt wird.

Derzeit werden zum Aufbau einer optischen Bank hauptsächlich Leichtbaumaterialien wie Aluminium oder Kohlefaser verwendet. Diese Materialen weisen eine hohe Stabilität und vergleichsweise geringe Wärmeausdehnung auf, sodass die optischen Systeme stabil montiert werden können. Für eine hohe Stabilität weisen optische Bänke normalerweise auch eine Dicke von bis zu mehreren Zentimetern auf. Auf diese Materialien lassen sich allerdings keine elektronischen Bauteile oder Leiterbahnen aufbringen, sodass Elektronik und optische Bank physikalisch getrennt sind. Beide Komponenten sind aber beispielsweise in einem System zur optischen Freiraumkommunikation zwingend nötig. Durch den Einsatz einer optischen Bank und separaten Leiterplatten zur Montage der elektrischen Bauteile, steigen Volumen und Gewicht des Kommunikationssystems.

Durch den separaten Aufbau einer optischen Bank und Leiterplatte, werden extrem leichte und kompakte Bauformen verhindert, da durch die Aufteilung zwischen optischer Bank und Leiterplatte zur Montage elektronischer Komponenten keine maximale Miniatursierung des Systems möglich ist.

EP 3 045 945 beschreibt eine opto-elektrische Hybridplatte mit einem Substrat mit einer Isolierschicht und einer Metallverstärkungsschicht. Ein elektrischer Schaltungsteil ist auf der Vorderseite des Substrats vorgesehen, und ein Lichtwellenleiterteil ist auf dessen Rückseite vorgesehen.

US 6 639 155 beschreibt eine Plattform zum Verbinden von integrierten Schaltungschips und -karten, wobei die Plattform ein mit Schaltkreisen versehener Laminatträger auf Fluorpolymerbasis ist, der Schutzbarrieren aus hochreinem Fluorpolymer auf seinen Oberflächen aufweist.

Aufgabe der Erfindung ist es einen kompakten elektrisch-optischen Aufbau zu realisieren.

Diese Aufgabe wird gelöst durch den elektrisch-optischen Aufbau gemäß Anspruch 1.

Erfindungsgemäß weist der elektro-optischen Aufbau mindestens eine optischen Komponenten und mehrere elektrische Komponenten auf, wobei die elektrischen Komponenten insbesondere zu einer elektrischen Schaltung miteinander verbunden sind. Bei den optischen Komponenten handelt es sich beispielsweise um Linsen, Spiegel, Gitter und dergleichen. Bei den elektrischen Komponenten handelt es sich beispielsweise um eine Laserdiode, einen Verstärker, einen Controller, weiteren aktive oder passive elektrische Komponenten und dergleichen. Erfindungsgemäß sind dabei die optischen Komponenten und die elektrischen Komponenten auf einer gemeinsamen Leiterplatte.

Insbesondere wird durch den elektrisch-optischen Aufbau ein optisches Kommunikationssystem bzw. ein Freistrahl-Kommunikationsaufbau auf einer einzelnen Leiterplatte realisiert, die gleichzeitig als Leiterplatte für die benötigte elektrische Schaltung, als auch als optische Bank für die Montage der optischen Komponenten dient. Eine separate optische Bank, die die Komplexität und den Raumbedarf des Systems erhöhen würde, wird hierdurch vermieden.

Erfindungsgemäß ist die Leiterplatte im Querschnitt symmetrisch aufgebaut bzgl. der Schichtenreihenfolge. Hierdurch wird der Effekt der einseitigen lokalen Wärmeeinbringung durch die elektrischen Komponenten reduziert und insbesondere thermische Spannungen minimiert durch eine homogene Wärmeverteilung innerhalb der Leiterplatte.

Vorzugsweise sind die elektrischen Komponenten durch Leiterbahnen miteinander verbunden, wobei die Leiterbahnen in einer äußeren Kupferschicht integriert sind, insbesondere einätzbar sind. Insbesondere können bei der äußeren Schicht auch andere Materialen als Kupfer verwendet werden, um die elektrischen Komponenten elektrisch miteinander zu verbinden. Auch das Herstellungsverfahren der Leiterbahn ist nicht auf Ätzen beschränkt. Somit wird durch die Integration der Leiterbahnen ein kompakter elektrisch-optischer Aufbau geschaffen, der auf einer einzelnen Leiterplatte realisiert wird.

Vorzugsweise weist die Leiterplatte einen Wärmeausdehnungskoeffizienten von kleiner als 9 µm/K auf. Hierdurch wird sichergestellt, dass optische Komponenten auf der Leiterplatte auch bei unterschiedlichen Temperaturen, insbesondere bei Wärmeeintrag durch die elektrischen Komponenten, eine stabile Position zueinander behalten, sodass das optische System, angeordnet auf der Leiterplatte, nicht durch die Wärmeausdehnung gestört wird.

Erfindungsgemäß weist der elektro-optische Aufbau einen plattenförmigen Grundkörper auf. Plattenförmig bedeutet hierbei, dass der Grundkörper eine geringe Höhe gegenüber Länge und Breite des Grundkörpers aufweist. Die Höhe des Grundkörpers beträgt wenige Millimeter, wohingegen die Länge und Breite des Grundkörpers mehrere Zentimeter betragen kann. Dabei besteht der Grundköper auf einem Invar-Material. Bei dem Invar-Material handelt es sich um eine Klasse von Legierungen, insbesondere auf Eisen-, Nickel- und Kobaltbasis, welche allesamt einen geringen Wärmeausdehnungskoeffizienten aufweisen. Durch die erfindungsgemäße Verwendung von einem Invar-Material wird gewährleistet, dass der Grundkörper nur eine sehr geringe Wärmeausdehnung aufweist, sodass auf der erfindungsgemäßen Leiterplatte gleichzeitig elektrische und optische Komponenten angeordnet werden können ohne, dass der lokale Wärmeintrag der elektrischen Komponenten zu einer Störung des durch die optischen Komponenten gebildeten optischen Systems führt. Insbesondere weist dabei der Grundkörper einen Wärmeausdehnungskoeffizienten von kleiner als 9 µm/K auf.

Erfindungsgemäß handelt es sich beim dem Invar-Material um eine FeNiCo-Legierung mit 25 bis 35 Massen-% Ni und bis zu 20 Massen-% Co. Durch das Legieren von Kobalt kann der Wärmeausdehnungskoeffizient weiter reduziert werden. Hierunter fallen insbesondere die kommerziell erhältlichen Legierungen Inovco^{®} sowie Kovar^{®}.

Vorzugsweise ist der Grundkörper mit Kupfer beschichtet bzw. plattiniert, um die Wärmeleitfähigkeit der Leiterplatte zu erhöhen und eine effiziente Wärmeverteilung innerhalb der Leiterplatte zu gewährleisten. Besonders bevorzugt ist der Grundkörper auf beiden Seiten mit Kupfer beschichtet. Hierdurch wird die Wärmeleitfähigkeit des Grundkörpers weiter verbessert. Auch auf der zweiten Seite ist insbesondere auf dem Kupfer eine Füllerschicht angeordnet.

Auf dem Kupfer ist insbesondere eine Füllerschicht angeordnet. Durch die Füllerschicht, welche elektrisch isolierend ist, wird der kupferplatinierte Grundkörper von den Strömen der elektrischen Komponenten getrennt. Hierdurch ist es möglich auf der Füllerschicht elektrische Komponenten anzuordnen und diese entsprechend einem Schaltplan durch Leiterbahnen zu verbinden.

Vorzugsweise weist die Leiterplatte weitere Schichten aus Kupfer und Füllerschichten auf.

Vorzugsweise sind mehrere Invar-Schichten innerhalb der Leiterplatte vorgesehen. Hierdurch ist es möglich eine stabile Leiterplatte aufzubauen und Auswirkungen thermischer Spannungen zu minimieren.

Vorzugsweise handelt es sich bei der Füllerschicht um vorimprägnierte Fasern, welche geeignet sind den Grundkörper von den elektrischen Komponenten elektrisch zu isolieren, wo dies erforderlich ist. Vorimprägnierte Fasern werden dabei üblicherweise durch den Begriff Prepreg (englische Kurzform für: preimpregnated fibres) bezeichnet. Diese weisen üblicherweise ein mit einem Harz imprägniertes Textil oder Faseranordnung auf.

Vorzugsweise ist auf der Füllerschicht eine weitere Kupferschicht angeordnet, bzw. ist als äußerste Schicht eine Kupferschicht vorgesehen zur Aufnahme bzw. zum Ausbilden der Leiterbahnen, welche die elektrischen Komponenten miteinander verbinden. Hierbei kann durch Ätzen oder dergleichen Teile dieser äußeren Kupferschicht entfernt werden, sodass lediglich die elektrischen Verbindungen gemäß einem Schaltplan überbleiben und die elektrischen Komponenten eklektisch miteinander verbinden. Anstelle von Kupfer können auch andere Metalle oder Legierungen verwendet werden, welche geeignet sind einen elektrischen Kontakt zwischen den elektrischen Komponenten zu gewährleisten.

Vorzugsweise wird der Grundkörper als Erdung für die elektrische Schaltung, gebildet durch die elektrischen Komponenten, oder als deren Stromversorgung verwendet.

Vorzugsweise weist die Leiterplatte eine Vielzahl von Löchern auf zur Befestigung der optischen und elektrischen Komponenten. Dabei können thermisch isolierte Löcher vorgesehen sein, insbesondere für die optischen Komponenten. Diese thermisch isolierten Löcher sind mit Kupfer ausgekleidet, welche keine metallische Verbindung zum Grundkörper aufweisen. Alternativ oder zusätzlich hierzu kann die Leiterplatte thermisch verbundene Löcher aufweisen, insbesondere zur Aufnahme der elektrischen Komponenten, sodass deren abgegebene Wärme effizient in den Grundkörper eingeleitet werden kann. Dabei sind die Löcher mit Kupfer ausgekleidet bzw. mit dem Material der äußersten Schicht. Diese Auskleidung ist unmittelbar verbunden mit dem Grundkörper bestehend auf Invar. Durch die metallische Verbindung wird erzeugte Wärme unmittelbar in den Grundkörper abgeleitet und möglichst gleichmäßig innerhalb der Leiterplatte verteilt.

Nachfolgen wird die Erfindung anhand der beigefügten Zeichnungen näher erläutert. Es zeigen:
- Figur 1: einen ersten Schichtaufbau einer Leiterplatte im Querschnitt für einen erfindungsgemäßen elektrisch-optischen Aufbau,
- Figur 2: einen zweiten Schichtaufbau einer Leiterplatte im Querschnitt für einen erfindungsgemäßen elektrisch-optischen Aufbau,
- Figur 3: einen erfindungsgemäßen elektrisch-optischen Aufbau,
- Figur 4: thermisch isolierte Löcher gemäß der Erfindung und
- Figur 5: thermisch verbunden Löcher gemäß der Erfindung.

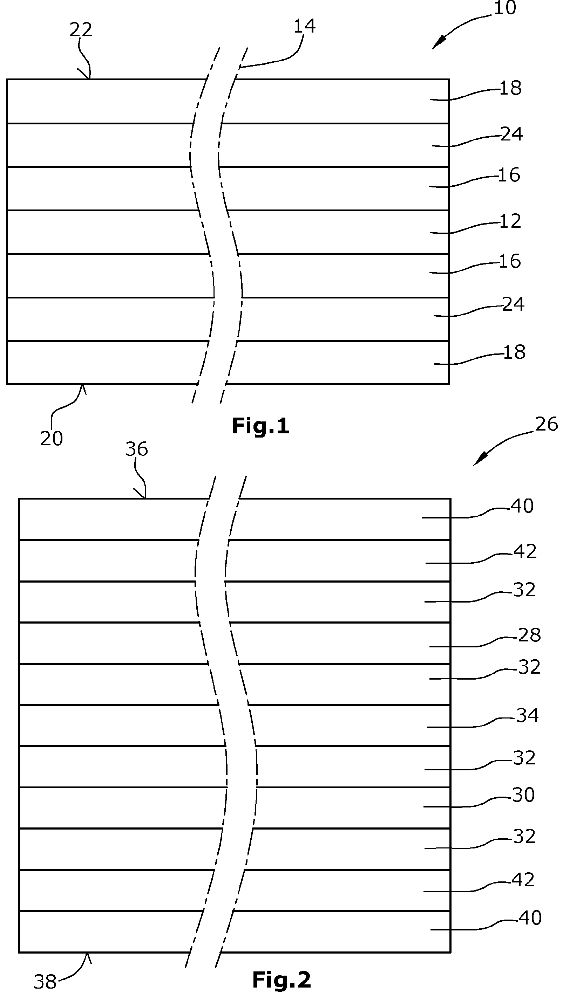

In einer ersten Konfiguration einer Leiterplatte 10, gezeigt in der Figur 1, für einen erfindungsgemäßen elektrisch-optischen Aufbau, weist diese einen plattenförmigen Grundkörper 12 auf. Die plattenförmige Ausgestaltung des Grundkörpers 12 und der Leiterplatte 10 im Allgemeinen wird durch die Auslassungszeichen 14 in der Figur 1 dargestellt. Dabei weist die Leiterplatte 10 lediglich eine Dicke von wenigen Millimetern, insbesondere 1,5 mm - 10 mm auf. Dagegen weist die Leiterplatte eine Länge und Breite von mehreren Zentimetern auf und ist dabei groß genug, um sämtlichen elektronischen und optischen Komponenten aufzunehmen. Der plattenförmige Grundkörper 12 der Leiterplatte besteht aus einem Invar-Material, beispielsweise aus Fe65Ni35. Der Grundkörper ist beidseitig mit einer Kupferschicht 16 beschichtet bzw. platiniert. Weiterhin weist die Leiterplatte 10 eine äußere Kupferschicht 18 sowohl an der Unterseite 20 als auch an der Oberseite 22 auf. Somit ist der Aufbau der Leiterplatte 10 symmetrisch um den Grundkörper bestehend auf dem Invar-Material. In die äußerste Kupferbeschichtung 18 an der Oberseite 22 können Leiterbahnen integriert sein, die die elektrischen Komponenten, welche sich auf der Leiterplatte anordnen lassen, gemäß einem Schaltplan elektrisch miteinander verbinden. Zwischen der äußersten Kupferschicht 18 und der unmittelbar mit dem Grundkörper 12 verbundenen Kupferschicht 16 ist jeweils eine Füllerschicht 24 angeordnet, welche die äußere Kupferschicht 18 jeweils von der inneren Kupferschicht 16 elektrisch isoliert. Bei der Füllerschicht 24 handelt es sich um ausgehärtete vorimprägnierte Fasern, sogenanntes Prepreg.

Gemäß einer zweiten Ausführungsform gezeigt in Figur 2, weist die Leiterplatte 26 einen ersten plattenförmigen Grundkörper 28 aus einem Invar-Material auf, sowie einen zweiten plattenförmigen Grundkörper 30 ebenfalls aus einen Invar-Material. Sowohl der erste Grundkörper 28 als auch der zweite Grundköper 30 sind beidseitig unmittelbar durch Kupferschichten 32 beschichtet. Der kupferplatinierte erste Grundkörper 28 ist mit den kupferplatinierten zweiten Grundkörper 30 über eine Füllerschicht 34 miteinander verbunden. Sowohl an der Oberseite 36 als auch an der Unterseite 38 ist eine äußere Kupferschicht 40 angeordnet, die jeweils über eine Füllerschicht 42 mit den Grundkörper verbunden ist. Auch in diesem Ausführungsbeispiel ist der Aufbau der Leiterplatte 26 symmetrisch, um thermische Spannungen auf Grund der Wärme, welche durch die an der Oberfläche 36 angeordneten elektronischen Komponenten eingebracht wird, zu minimieren.

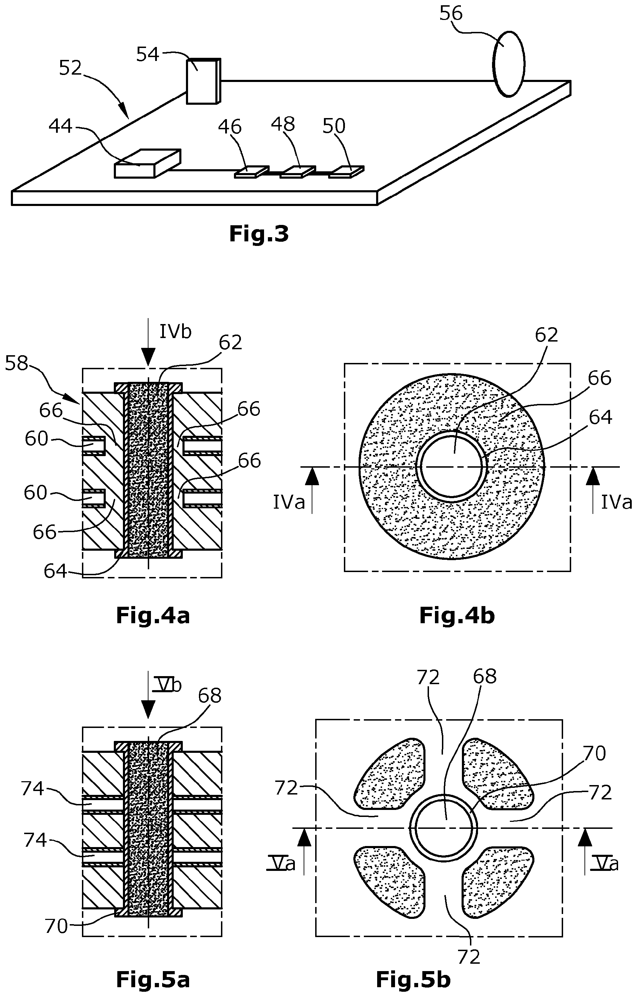

Figur 3 zeigt schematisch einen elektrisch-optischen Aufbau. Dabei sind elektrische Komponenten, wie beispielsweise Laserdiode 44, Verstärker 46, Controller 48 und Spannungsversorgung 50, auf einer gemeinsamen Leiterplatte 52 angeordnet. Die gemeinsame Leiterplatte 52 weist dabei beispielsweise wieder einen beidseitig kupferplatinierten Invar-Grundköper auf. Weiterhin sind auf der gemeinsamen Leiterplatte 52 optische Komponenten wie ein Spiegel 54 oder eine Linse 56 angeordnet zur Führung und Modifikation des Laserlichts der Laserdiode 44. Aufgrund des Aufbaus der gemeinsamen Leiterplatte 52 weist diese einen Wärmeausdehnungskoeffizienten von kleiner als 9 µm/K auf, sodass die relative Position der optischen Komponenten zueinander sich unwesentlich ändert durch den lokalen Wärmeintrag, erzeugt durch die elektrischen Komponenten 44, 46, 48 und 50. Hierdurch ist es möglich elektrische Komponenten 44, 46, 48 und 50 zusammen mit optischen Komponenten 54, 56 auf einer gemeinsamen Leiterplatte 52 anzuordnen. Eine gesonderte optische Bank entfällt. Hierdurch wird der Aufbau des elektrisch-optischen Systems stark vereinfacht.

Eine weitere Steuerung des Wärmehaushalts der Leiterplatte erfolgt über die isolierten Befestigungslöcher, insbesondere für optische Komponenten gezeigt in Figur 4. Die Leiterplatte 58 weist zwei Invar-Grundkörper 60 auf, die jeweils kupferplatiniert sind. Eine Bohrung 62 ist von Innen kupferbeschichtet 64. Dabei weist die Kupferbeschichtung keine metallische Verbindung zu den beiden Invar-Grundköpern 60 auf. Insbesondere wird durch die Lücke 66 sichergestellt, dass der Wärmeübertrag von den Invar-Grundkörpern 60 auf die Befestigungsstellen bzw. an der Befestigungsstelle befestigten optischen Komponenten gering ist.

Alternativ können insbesondere elektrische Komponenten in thermisch verbundenen Löchern, gezeigt in Figur 5, befestigt werden. Diese weisen eine Bohrung 68 auf, deren Innenfläche mit Kupfer 70 beschichtet ist. Dabei ist die innere Beschichtung 70 über Stege 72 unmittelbar mit den beiden vorhandenen Invar-Grundkörpern 74 verbunden, sodass Wärme, erzeugt durch die in der Bohrung 68 befestigten elektrischen Komponente, effektiv über eine große Fläche, gebildet durch die kupferplatinierten Invar-Kerne, abgeleitet werden kann. Hierdurch wird entstehende Wärme schnell verteilt, sodass eine Verringerung der lokalen Temperaturüberhöhung zu einer verringerten thermischen Spannung führt.

## Patentansprüche

1. Elektrisch-optischer Aufbau, mit
mindestens einer optischen Komponente (54, 56) und
mehreren elektrischen Komponenten (44, 46, 48, 50) einer elektrischen Schaltung,
wobei die optische Komponente (54, 56) und elektrische Komponenten (44, 46, 48, 50) auf einer gemeinsamen Leiterplatte (10, 26, 52) angeordnet sind, so dass die gemeinsame Leiterplatte ebenfalls als optische Bank fungiert,
**dadurch gekennzeichnet, dass**
die Leiterplatte (10, 26, 52) im Querschnitt einen symmetrischen Schichtaufbau aufweist,
die Leiterplatte (10, 26, 52) einen plattenförmigen Grundkörper (12, 28) aufweist, wobei der Grundkörper (12, 28) aus einem Invar-Material besteht, und
es sich bei dem Invar-Material um eine FeNiCo-Legierung mit 25 bis 35 Massen-% Ni und bis zu 20 Massen-% Co handelt.

2. Elektrisch-optischer Aufbau nach Anspruch 1, **dadurch gekennzeichnet, dass** die elektrischen Komponenten (44, 46, 48, 50) durch Leiterbahnen miteinander verbunden sind, wobei die Leiterbahnen in die Leiterplatte (10, 26, 52) integriert sind.

3. Elektrisch-optischer Aufbau nach einem der Ansprüche 1 oder 2, **dadurch gekennzeichnet, dass** der Grundkörper (12, 28) auf beiden Seiten mit Kupfer (16, 32) beschichtet ist.

4. Elektrisch-optischer Aufbau nach einem der Ansprüche 1 bis 3, **dadurch gekennzeichnet, dass** es sich bei dem elektrisch-optischer Aufbau um einen Freistrahl-Kommunikationsaufbau handelt.

## Claims

1. Electro-optical structure, comprising
at least one optical component (54, 56), and
several electrical components (44, 46, 48, 50) of an electrical circuit,
wherein the optical component (54, 56) and electrical components (44, 46, 48, 50) are arranged on a common printed circuit board (10, 26, 52) so that the common printed circuit board also functions as an optical bench,
**characterized in that**
the printed circuit board (10, 26, 52) has a symmetrical layer structure in cross-section,
the printed circuit board (10, 26, 52) has a plate-shaped base body (12, 28), the base body (12, 28) consisting of an Invar material, and
the Invar material is an FeNiCo alloy with 25 to 35 mass-% Ni and up to 20 mass-% Co.

2. Electro-optical structure according to claim 1, **characterized in that** the electrical components (44, 46, 48, 50) are interconnected by conductor tracks, the conductor tracks being integrated into the printed circuit board (10, 26, 52).

3. Electro-optical structure according to any one of claims 1 or 2, **characterized in that** the base body (12, 28) is coated with copper (16, 32) on both sides.

4. Electro-optical structure according to any one of claims 1 to 3, **characterized in that** the electro-optical structure is a free-beam communication structure.

## Revendications

1. Ensemble électro-optique avec:
au moins un composant optique (54, 56) et
plusieurs composants électriques (44, 46, 48, 50) d'un circuit électrique,
où le composant optique (54, 56) et les composants électriques (44, 46, 48, 50) sont disposés sur une carte de circuit imprimé commune (10, 26, 52), de sorte que la carte de circuit imprimé commune sert également de banc optique,
**caractérisé en ce que**
la carte de circuit imprimé (10, 26, 52) présente une structure en couches symétrique en coupe transversale,
la carte de circuit imprimé (10, 26, 52) présente un corps de base en forme de plaque (12, 28), où le corps de base (12, 28) consiste en un matériau Invar, et
le matériau Invar est un alliage FeNiCo avec 25 à 35 % en masse de Ni et jusqu'à 20 % en masse de Co.

2. Ensemble électro-optique selon la revendication 1, **caractérisé en ce que** les composants électriques (44, 46, 48, 50) sont reliés entre eux par des pistes conductrices, où les pistes conductrices sont intégrées dans la carte de circuit imprimé (10, 26, 52).

3. Ensemble électro-optique selon l'une des revendications 1 ou 2, **caractérisé en ce que** le corps de base (12, 28) est revêtu de cuivre (16, 32) sur les deux côtés.

4. Ensemble électro-optique selon l'une des revendications 1 à 3, **caractérisé en ce que** l'ensemble électro-optique est un ensemble de communication à faisceau libre.
